# EUROPÄISCHE PATENTSCHRIFT

(11) **EP 2 870 623 B1**
(45) Veröffentlichungstag und Bekanntmachung des Hinweises auf die Patenterteilung: **13.01.2021**
(21) Anmeldenummer: 13735262.1
(22) Anmeldetag: 09.07.2013
(51) Int. Cl.: H01L 21/673

(54) **PROZESSBOX, ANORDNUNG UND VERFAHREN ZUM PROZESSIEREN EINES BESCHICHTETEN SUBSTRATS**
PROCESS BOX, ASSEMBLY AND METHOD FOR PROCESSING COATED SUBSTRATES
BOÎTIER DE PROCESSUS, AGENCEMENT ET PROCÉDÉ DE TRAITEMENT D'UN SUBSTRAT REVÊTU

(30) Priorität: 09.07.2012 EP 12175596
(43) Veröffentlichungstag der Anmeldung: 13.05.2015
(73) Patentinhaber: (CNBM) Bengbu Design & Research Institute for Glass Industry Co., Ltd., Bengbu (CN)
(72) Erfinder: PALM, Jörg, 80797 München (DE); FÜRFANGER, Martin, 85643 Steinhöring (DE); JOST, Stefan, 81543 München (DE)
(74) Vertreter: Gebauer, Dieter Edmund
(86) Internationale Anmeldenummer: PCT/EP2013/064516
(87) Internationale Veröffentlichungsnummer: WO 2014/009386

(56) Entgegenhaltungen:
- WO-A1-01/80291
- WO-A2-2007/077171
- US-A1- 2003 094 446
- US-A1- 2005 238 476

## Beschreibung

Die Erfindung betrifft eine Prozessbox, eine Anordnung und ein Verfahren zum Prozessieren eines beschichteten Substrats. Sie bezieht sich insbesondere auf die Prozessierung eines Substrats, das mit Vorläuferschichten zur Herstellung eines Absorbers aus einem Verbindungshalbleiter für Dünnschichtsolarzellen beschichtet ist.

Photovoltaische Schichtensysteme zur direkten Umwandlung von Sonnenlicht in elektrische Energie sind hinlänglich bekannt. Diese werden gemeinhin als "Solarzellen" bezeichnet, wobei sich der Begriff "Dünnschichtsolarzellen" auf Schichtensysteme mit geringen Dicken von nur wenigen Mikrometern bezieht, welche Substrate für eine ausreichende mechanische Festigkeit benötigen. Bekannte Substrate umfassen anorganisches Glas, Kunststoffe (Polymere) oder Metalle, insbesondere Metalllegierungen, und können in Abhängigkeit von der jeweiligen Schichtdicke und den spezifischen Materialeigenschaften als starre Platten oder biegsame Folien ausgestaltet sein.

Hinsichtlich der technologischen Handhabbarkeit und des Wirkungsgrads haben sich Dünnschichtsolarzellen mit Absorbern aus Verbindungshalbleitern als vorteilhaft erwiesen. In der Patentliteratur wurden Dünnschichtsolarzellen bereits vielfach beschrieben. Lediglich beispielhaft sei diesbezüglich auf die Druckschriften DE 4324318 C1 und EP 2200097 A1 verwiesen.

In Dünnschichtsolarzellen werden überwiegend Verbindungshalbleiter aus Chalkopyritverbindungen, insbesondere Kupfer-Indium/Gallium-Dischwefel/Diselenid, abgekürzt durch die Formel Cu(In,Ga)(S,Se)₂, oder Kesterit-Verbindungen, insbesondere Kupfer-Zink/Zinn-Dischwefel/Diselenid, abgekürzt durch die Formel Cu₂(Zn,Sn)(S,Se)₄ als Absorber eingesetzt. Von den verschiedenen Möglichkeiten den Verbindungshalbleiter herzustellen, haben sich in den letzten Jahren im Wesentlichen zwei Verfahren durchgesetzt. Dies ist die Ko-Verdampfung der Einzelelemente auf ein heißes Substrat sowie das sukzessive Aufbringen der Elemente in Einzelschichten (Vorläufer- bzw. Prescursorschichten) auf ein kaltes Substrat, beispielsweise durch Sputtern, verbunden mit einer schnellen Wärmebehandlung (RTP = Rapid Thermal Processing), bei der die eigentliche Kristallbildung und Phasenumwandlung der Vorläuferschichten zum Verbindungshalbleiter erfolgt. Die letztgenannte zweistufige Vorgehensweise ist beispielsweise in J. Palm et al., "CIS module pilot processing applying concurrent rapid selenization and sulfurization of large area thin film precursors", Thin Solid Films 431-432, S. 414-522 (2003) eingehend beschrieben.

In der großtechnischen Fertigung von Dünnschichtsolarmodulen erfolgt die RTP-Wärmebehandlung von Vorläuferschichten in In-Line-Anlagen, in denen die beschichteten Substrate der Reihe nach verschiedenen Prozesskammern zugeführt werden. Ein solches Verfahren ist beispielsweise aus der EP 0662247 B1 bekannt.

Die RTP-Wärmebehandlung von Vorläuferschichten ist ein komplexer Prozess der schnelle Aufheizraten im Bereich einiger K/s, eine homogene Temperaturverteilung über das Substrat (lateral) und über die Substrat-Dicke, Maximal-Temperaturen oberhalb von 500°C, sowie eine genaue Kontrolle der Prozessatmosphäre erfordert. Insbesondere ist bei der Herstellung einer Chalkopyritverbindung ein ausreichend hoher, kontrollierbarer und reproduzierbarer Partialdruck der beispielsweise auf das Substrat aufgebrachten leichtflüchtigen Chalkogenelemente (Se und/oder S) und eine kontrollierte Prozessgas-Zufuhr (z.B. H₂, N₂, Ar, H₂S, H₂Se, S-Gas, Se-Gas) zu gewährleisten. Beispielsweise erfordert eine In-Line-Selenisierung eines metallischen CuInGa-Vorläuferschichtenstapels eine ausreichende Se-Menge für eine vollständige Selenisierung. Ein deutlicher Se-Verlust führt zu einer unvollständigen Umwandlung der Vorläuferschichten zur Chalkopyritverbindung und selbst ein schwacher Se-Verlust resultiert in einer Leistungseinbuße des fertigen Dünnschichtsolarmoduls.

Es ist bekannt, den Prozessraum um das beschichtete Substrat durch eine Prozessbox zu begrenzen. Die Prozessbox ermöglicht, den Partialdruck von leicht flüchtigen Chalkogenkomponenten, wie Selen oder Schwefel, während der Wärmebehandlung zumindest weitestgehend konstant zu halten. Außerdem wird die Exposition der Prozesskammer mit korrosiven Gasen reduziert. Eine solche Prozessbox ist beispielsweise aus der DE 102008022784 A1 bekannt.

In den zur großtechnischen Fertigung von Dünnschichtsolarmodulen eingesetzten In-Line-Anlagen durchlaufen die beschichteten Substrate bzw. damit beladenen Prozessboxen die verschiedenen Prozesskammern im Indexbetrieb, bei denen sie taktweise in die jeweils nächste Prozesskammer transportiert werden. Die Prozesskammern sind generell als gasdicht verschließbare (evakuierbare) Kammern ausgeführt, da die gesamte Prozessstrecke zum Entfernen von Sauerstoff und Wasser abgepumpt bzw. evakuiert werden muss. Obgleich eine Prozessierung der Substrate üblicher Weise bei Normaldruck (bzw. geringem Unterdruck aus Sicherheitsgründen) erfolgt, ist eine Gasdichtigkeit der Prozesskammern erforderlich, um die Eindiffusion von Sauerstoff und Wasser in die Prozessstrecke und das Ausströmen von toxischen Gasen zu vermeiden. Lediglich eine Eingangs- und Ausgangsschleuse werden zyklisch abgepumpt.

Allgemein ist die Konstruktion der Prozesskammern komplex und technisch anspruchsvoll, da die erforderliche Vakuumdichtigkeit höchste Anforderungen an die verwendeten Materialien und Anlagenkomponenten wie Vakuumdurchführungen, insbesondere Drehdurchführungen, Ventile, Transportrollen, Gasandockstationen, Kühlplatten und Vakuumschieber stellen. Aus diesem Grund nehmen die Investitionskosten für diesen Prozessschritt einen nicht unwesentlichen Anteil an den gesamten Investitionskosten einer Solarfabrik ein. Zudem hat sich in der Praxis gezeigt, dass die technisch aufwändigen und vergleichsweise teuren Komponenten, welche für eine Vakuumdichtigkeit der Prozesskammern ausgelegt sind, durch den Transport der beschichteten Substrate bzw. Prozessboxen, das Heizen auf hohe Maximaltemperaturen von mehr als 500°C, sowie durch die korrosive Prozessatmosphäre einem deutlich erhöhten Verschleiß ausgesetzt sind und undicht werden können. Bei einem Ausfall ist die komplette Fertigungskette durch die erforderlichen Wartungsarbeiten unterbrochen.

Die US-Patentanmeldung Nr. 2005/0238476 A1 zeigt eine Vorrichtung zum Transportieren eines Substrats in einer kontrollierten Atmosphäre mit einem Gehäuse, das einen evakuierbaren Substratraum für das Substrat und einen Nebenraum umfasst. Substrat- und Nebenraum sind durch eine Trennwand mit Nanoporen voneinander getrennt, wobei die Trennwand eine auf dem Knudsen-Prinzip (Thermoosmose) basierende Mikropumpe bildet. Der Substratraum weist eine Kühlplatte (Dekontaminationsplatte) auf, wobei die Trennwand nicht zwischen Substrat und Kühlplatte angeordnet ist. Vielmehr ist die Kühlplatte stets in gegenüberliegender Position zum Substrat angeordnet. Zudem ist der Nebenraum durch die heizbare Trennwand von dem durch die Kühlplatte gekühlten Gehäuseabschnitt bzw. Substratraum thermisch abgekoppelt. Für den Pumpmechanismus ist eine Heizung erforderlich.

Demgegenüber liegt die Aufgabe der vorliegenden Erfindung darin, eine Möglichkeit zu schaffen, dass beschichtete Substrate in einer technisch wesentlich einfacheren und kostengünstigeren Anlage einer Wärmebehandlung unterzogen werden können. Diese und weitere Aufgaben werden nach dem Vorschlag der Erfindung durch eine Prozessbox, eine Anordnung und ein Verfahren zum Prozessieren eines beschichteten Substrats gemäß den nebengeordneten Patentansprüchen gelöst. Bevorzugte Ausführungsformen der Erfindung gehen aus den Merkmalen der Unteransprüche hervor.

Erfindungsgemäß ist eine Prozessbox zum Prozessieren eines beschichteten Substrats gezeigt, die wahlweise als transportierbare oder stationäre Prozessbox eingesetzt werden kann.

Im Sinne der Erfindung bezieht sich der Ausdruck "Substrat" auf einen flächigen Körper, der über zwei einander entgegen gesetzte Oberflächen verfügt, wobei auf einer der beiden Oberflächen ein typischer Weise eine Mehrzahl Schichten enthaltender Schichtenaufbau aufgebracht ist. Die andere Oberfläche des Substrats ist in der Regel unbeschichtet. Beispielsweise handelt es sich um ein mit Precursor- bzw. Vorläuferschichten eines Verbindungshalbleiters (z.B. Chalkopyrit- oder Kesteritverbindung) beschichtetes Substrat zur Herstellung eines Dünnschichtsolarmoduls, das einer RTP-Wärmebehandlung unterzogen werden muss.

Die erfindungsgemäße Prozessbox umfasst ein Gehäuse, durch das ein gasdicht verschließbarer (evakuierbarer) Hohlraum geformt bzw. umgrenzt ist. Die lichte Höhe des Hohlraums ist vorzugsweise so bemessen, dass in möglichst kurzer Zeit Gase abgepumpt und die hohen Anforderungen bezüglich Sauerstoffgehalt und Wasserpartialdruck bei einer RTP-Wärmebehandlung erfüllt werden können. Das Gehäuse kann grundsätzlich aus jedem für die beabsichtigte Verwendung geeigneten Material, beispielsweise Metall, Glas, Keramik, Glaskeramik, carbonfaserverstärkte Kohlenstoffwerkstoffe oder Graphit, gefertigt sein.

Wesentlich hierbei ist, dass das Gehäuse der Prozessbox einen oder mehrere Gehäuseabschnitte aufweist, die jeweils dazu ausgebildet sind, eine Wärmebehandlung durch auf den Gehäuseabschnitt auftreffende elektromagnetische Heizstrahlung zu ermöglichen. Die zur Wärmebehandlung dienenden Gehäuseabschnitte können zu diesem Zweck transparent, teiltransparent oder undurchsichtig sein für elektromagnetische Heizstrahlung zum Prozessieren des Substrats. Beispielsweise bestehen die zur Wärmebehandlung dienenden Gehäuseabschnitte aus Glaskeramik. Die zur Wärmebehandlung dienenden Gehäuseabschnitte können insbesondere auch ein Material (z.B. Graphit) enthalten oder aus einem solchen bestehen, welches geeignet ist, die elektromagnetische Heizstrahlung von Heizstrahlern zumindest teilweise, insbesondere vollständig, zu absorbieren, um selbst aufgeheizt zu werden. Der aufgeheizte Gehäuseabschnitt kann dann als sekundäre Wärmequelle zum Aufheizen des Substrats dienen, was insbesondere zu einer Homogenisierung der Wärmeverteilung führen kann.

Das Gehäuse der Prozessbox umfasst weiterhin einen oder mehrere temperierbare bzw. aktiv kühlbare (erste) Gehäuseabschnitte, deren Temperatur auf einen vorgebbaren Temperaturwert einstellbar ist. Die Gehäuseabschnitte sind zu diesem Zweck jeweils mit einer (externen) Temperier- bzw. Kühleinrichtung wärmetechnisch koppelbar bzw. gekoppelt. Die ersten Gehäuseabschnitte sind beispielsweise an die Kühleinrichtung (fluidisch) angeschlossen bzw. anschließbar und können daher gekühlt werden, wohingegen die zweiten Gehäuseabschnitte an die Kühleinrichtung nicht angeschlossen sind und daher nicht gekühlt werden können. Des Weiteren umfasst das Gehäuse einen oder mehrere nicht temperierbare bzw. kühlbare, d.h. nicht mit der Temperier- bzw. Kühleinrichtung koppelbare bzw. gekoppelte, (zweite) Gehäuseabschnitte, bei welchen es sich insbesondere um jene Gehäuseabschnitte handelt, die eine Wärmebehandlung durch auf den Gehäuseabschnitt auftreffende elektromagnetische Heizstrahlung ermöglichen, also im Strahlungsfeld der Heizstrahler liegen. Die ersten Gehäuseabschnitte sind von den zweiten Gehäuseabschnitten verschieden.

Die temperierbaren bzw. kühlbaren (ersten) Gehäuseabschnitte sind in Bezug auf die Temperatur des Substrats und jener Gehäuseabschnitte, die eine Wärmebehandlung durch auftreffende elektromagnetische Heizstrahlung ermöglichen und im Strahlungsfeld der Heizstrahler liegen, aktiv kühlbar. Die temperierbaren bzw. kühlbaren Gehäuseabschnitte der Prozessbox können vor, während und/oder nach einer Wärmebehandlung des beschichteten Substrats temperiert bzw. aktiv gekühlt werden.

Wie hier und im Weiteren verwendet, bezieht sich der Ausdruck "kühlbar" auf eine Temperierung (Kühlung) des Gehäuseabschnitts auf eine Temperatur, die niedriger ist als die Temperatur des Substrats bei der Wärmebehandlung bzw. jener Gehäuseabschnitte, die eine Wärmebehandlung durch auftreffende elektromagnetische Heizstrahlung ermöglichen und im Strahlungsfeld der Heizstrahler liegen. Beispielsweise wird der Gehäuseabschnitt auf eine Temperatur im Bereich von 20°C bis 200°C temperiert. Durch diese Temperierung (Kühlung) können die in der Vakuumtechnik üblichen Kunststoffdichtungen (Elastomere, Fluorelastomere) und andere vergleichsweise kostengünstige Standardkomponenten zur Vakuumabdichtung der Prozessbox verwendet werden, die jedoch Temperaturen über 200°C dauerhaft nicht überstehen.

Weiterhin umfasst das Gehäuse der Prozessbox wenigstens eine in den Hohlraum mündende, (beispielsweise durch ein Ventil) verschließbare Gasdurchführung zum Evakuieren des Hohlraums und Einleiten von Prozessgas in den Hohlraum. Die Gasdurchführung kann zu diesem Zweck insbesondere in den Zwischenraum münden. Das Prozessgas kann beispielsweise reaktive Gase wie H₂S, H₂Se, S-Dampf, Se-Dampf oder H₂ sowie Inertgase wie N₂, He oder Ar enthalten.

In der erfindungsgemäßen Prozessbox ist der durch das Gehäuse ausgebildete Hohlraum durch wenigstens eine Trennwand in einen Prozessraum zum Aufnehmen des beschichteten Substrats und einen Zwischenraum unterteilt, wobei die Trennwand zwischen dem beschichteten Substrat und dem aktiv gekühlten, d.h. mit der Kühleinrichtung koppelbaren bzw. gekoppelten, (ersten) Gehäuseabschnitt angeordnet ist. Der Prozessraum wird ausschließlich von der wenigstens einen Trennwand und einem oder mehreren nicht temperierbaren, d.h. nicht mit der Kühleinrichtung gekoppelten, (zweiten) Gehäuseabschnitten der Prozessbox umgrenzt.

Wesentlich ist, dass die Trennwand als Diffusionsbarriere (Dampfbarriere) für einen Gasaustausch zwischen Prozess- und Zwischenraum während der Wärmebehandlung dient, jedoch zumindest zeitweilig vor und nach der Wärmebehandlung einen Gasaustausch zwischen Prozess- und Zwischenraum ermöglicht, so dass ein Abpumpen gasförmiger Stoffe aus dem Prozessraum sowie eine Befüllung mit Prozessgas durch die Trennwand hindurch möglich ist. Die Trennwand verfügt zu diesem Zweck über eine oder mehrere Öffnungen bzw. Durchbrechungen, durch die Prozess- und Zwischenraum strömungstechnisch miteinander verbunden sind. Allgemein können die Öffnungen jede beliebige Form aufweisen, beispielsweise eine Schlitz- oder Rundlochform, und auch randständig angeordnet sein.

Bei einer vorteilhaften Ausgestaltung reicht die Trennwand nicht bis zu einer Gehäusewand, so dass eine Öffnung, insbesondere ein Spalt, zwischen Trennwand und Gehäusewand verbleibt.

Insbesondere kann die Trennwand aus einem porösen Material oder einem mit Röhren (gerade, schräge oder gewinkelte Röhren) versehenen Material bestehen oder ein solches Material umfassen.

Beispielsweise, jedoch nicht zwingend, ist eine kleinste Abmessung, beispielsweise ein Radius oder Durchmesser, einer jeweiligen Öffnung der Trennwand größer als die mittlere freie Weglänge der Gasteilchen im Prozessraum.

Allgemein wird durch die Trennwand ein Prozessraum zum Prozessieren des beschichteten Substrats gebildet, der durch die Trennwand vom Zwischenraum quasi-gasdicht abgetrennt ist. Im Unterschied zu einem offenen Prozessraum, der einen freien Gasaustausch zwischen Prozessraum und äußerer Umgebung erlaubt, sowie zu einem gasdichten Prozessraum, bei dem ein solcher Gasaustausch zwischen Prozessraum und äußerer Umgebung vollständig unterbunden ist, ist der Gasaustausch zwischen Prozessraum und Zwischenraum durch die Trennwand gehemmt. Diese Dampfbarriere beruht auf der Druckabhängigkeit der freien Weglänge: bei nahezu Normaldruck (700-1000mbar) ist die Diffusion durch die vergleichsweise kleinen Öffnungen gehemmt. Wird der Zwischenraum dagegen auf Drücke im Vorvakuumbereich (10-1000pbar) abgepumpt, ist die freie Weglänge stark erhöht und die Trennwand stellt nur noch eine schwache Diffusionsbarriere für den Gasaustausch dar. Der Prozessraum kann durch die Trennwand abgepumpt werden und Prozessgas strömt nach dem Abpumpen durch Einlass in die Prozessbox auch in den Prozessraum. Insbesondere kann durch die quasi-gasdichte Trennwand der Partialdruck von leicht flüchtigen Chalkogenkomponenten wie Selen oder Schwefel während der Wärmebehandlung im Prozessraum zumindest weitestgehend konstant gehalten werden.

Allgemein ist die erfindungsgemäße Prozessbox so ausgebildet, dass sie zur Beladung mit einem beschichteten Substrat und zum Entnehmen des prozessierten Substrats geöffnet oder verschlossen bzw. zusammengebaut und (zerstörungsfrei) wieder zerlegt werden kann.

Durch die erfindungsgemäße Prozessbox können mehrere Vorteile erreicht werden. So ist durch die gasdichte Ausbildung des Hohlraums mit wenigstens einer in den Hohlraum mündenden, verschließbaren Gasdurchführung ein Evakuieren des Prozessraums, insbesondere zum Abpumpen korrosiver Prozessgase und Verringern des Sauerstoffgehalts und Wasserpartialdrucks, sowie ein Spülen mit Inertgas und ein Befüllen mit Prozessgas möglich. Daher ist es nicht erforderlich, Schleusen und Prozessstationen zur Wärmebehandlung der Substrate gasdicht bzw. evakuierbar auszuführen, so dass sich die Anlage technisch stark vereinfacht und die Kosten für deren Herstellung und Wartung erheblich verringert werden können. Da korrosive Prozessgase ausschließlich im Hohlraum der Prozessbox vorhanden sind, kann ein erhöhter Verschleiß von Komponenten der Anlage wie Transportrollen zum Transport der Prozessbox oder Heizstrahler zum Wärmebehandeln des beschichteten Substrats vermieden werden. Zudem kann in vorteilhafter Weise auf bewegte Teile im vakuumfähigen Bereich (Prozessbox) der Anlage verzichtet werden. Eine Evakuierung des Hohlraums der Prozessbox kann schnell und effizient erreicht werden. Dies gilt gleichermaßen für eine Befüllung mit Prozessgas, wobei das Prozessgas kosteneffizient in minimaler Menge einsetzbar ist. Die Temperierung (aktive Kühlung) wenigstens eines Gehäuseabschnitts der Prozessbox ermöglicht eine Verringerung des Verschleißes insbesondere vakuumfähiger Komponenten der Prozessbox während der Wärmebehandlung und gegebenenfalls eine Unterstützung der aktiven Kühlung des beschichteten Substrats nach der Wärmebehandlung. Durch die als Diffusions- bzw. Dampfbarriere wirkende Trennwand kann eine Kondensation von während der Wärmebehandlung entstehenden flüchtigen Komponenten, wie der Chalkogenelemente Schwefel und Selen, auf dem temperierten (aktiv gekühlten) Gehäuseabschnitt verhindert werden, um so den Verlust an flüchtigen Komponenten in der Prozessatmosphäre zu minimieren und deren Partialdruck in der Prozessatmosphäre zumindest weitestgehend konstant zu halten. Der Verbrauch an flüchtigen Chalkogenelementen kann somit minimiert und die Qualität der hergestellten Verbindungshalbleiter verbessert werden. Zudem kann durch die Trennwand der Prozessraum gegenüber dem Hohlraum der Prozessbox noch weiter reduziert werden. Durch die gasdichte Prozessbox ist das in die Prozessbox eingebrachte Substrat vor Umwelteinflüssen gut geschützt. In einer Fertigungsanlage kann die beladene Prozessbox zwischen verschiedenen Prozessstationen transportiert werden, ohne dass das beschichtete Substrat aus der Prozessbox entfernt werden muss. Die Prozessbox kann wahlfrei mit einem oder mehreren beschichteten Substraten beladen werden, wobei eine Beladung mit mehreren Substraten zur Erhöhung des Durchsatzes bevorzugt sein kann.

Wie bereits ausgeführt, wird durch die Trennwand eine quasi-gasdichte Unterteilung des Hohlraums in einen Prozess- und Zwischenraum erreicht, wobei die Trennwand zu diesem Zweck mit einer oder mehreren Öffnungen versehen ist. Erfindungsgemäß ist die Trennwand so ausgebildet, dass während der Wärmebehandlung ein Massenverlust eines durch die Wärmebehandlung des beschichteten Substrats erzeugten gasförmiges Stoffs aus dem Prozessraum weniger als 50%, vorzugsweise weniger als 20%, stärker bevorzugt weniger als 10%, der während der Wärmebehandlung erzeugten Masse des gasförmigen Stoffs beträgt. Erfindungsgemäß ist die Trennwand zu diesem Zweck so ausgebildet, dass ein Flächenverhältnis, gebildet aus einer (gesamten) Öffnungsfläche der einen oder mehreren Öffnungen geteilt durch eine innere Oberfläche (Innenfläche) des Prozessraums, im Bereich von 5 x 10⁻⁵ bis 5 x 10⁻⁴ liegt. Hierdurch kann in vorteilhafter Weise erreicht werden, dass die (gesamte) Öffnungsfläche der einen oder mehreren Öffnungen der Trennwand einerseits hinreichend groß ist, um ein zügiges Evakuieren des Prozessraums sowie eine Befüllung mit Prozessgas zu ermöglichen, andererseits hinreichend klein ist, so dass die Trennwand als wirksame Dampf- bzw. Diffusionsbarriere für während der Wärmebehandlung im Prozessraum erzeugte flüchtige Komponenten dient.

Bei einer besonders vorteilhaften Ausgestaltung der Prozessbox enthält oder besteht die Trennwand aus einem Material, das einen solchen Wärmeausdehnungskoeffizienten hat, dass sich eine (gesamte) Öffnungsfläche der einen oder mehreren Öffnungen durch Erwärmen der Trennwand während der Wärmebehandlung auf maximal 50%, vorzugsweise maximal 30%, stärker bevorzugt maximal 10%, des Ausgangswerts (gesamte Öffnungsfläche vor der Wärmebehandlung) verringert. Vorteilhaft enthält oder besteht die Trennwand zu diesem Zweck aus einem Material mit einem Wärmeausdehnungskoeffizienten von mehr als 5 x 10⁻⁶ K⁻¹. Auf diese Weise wird eine temperaturgesteuerte Trennwand geschaffen, bei der einerseits im kälteren Zustand durch eine größere (gesamte) Öffnungsfläche ein besonders effizientes Abpumpen des Prozessraums sowie Befüllen des Prozessraums mit Prozessgas, andererseits im wärmeren Zustand während der Wärmebehandlung durch eine kleinere (gesamte) Öffnungsfläche eine besonders wirksame Hemmung der Diffusion von während der Wärmebehandlung erzeugten gasförmigen Stoffen vom Prozessraum in den Zwischenraum erreicht wird. Insbesondere kann die Trennwand so ausgebildet sein, dass während der Wärmebehandlung die (gesamte) Öffnungsfläche zumindest annähernd auf Null reduziert wird, so dass ein Gasaustausch zwischen Prozess- und Zwischenraum während der Wärmebehandlung praktisch vollständig unterbunden wird.

Bei einer vorteilhaften Ausgestaltung der erfindungsgemäßen Prozessbox umfasst das Gehäuse der Prozessbox einen Boden, einen Deckel, sowie einen Boden und Deckel miteinander verbindenden Rahmen. Boden und Deckel sind beispielsweise jeweils als Platten ausführt, wobei Boden und/oder Deckel aus einem solchen Material (z.B. Glaskeramik) bestehen, dass das beschichtete Substrat durch die Strahlungsenergie einer an der Unterseite des Bodens und/oder Oberseite des Deckels zugeführten Heizstrahlung wärmebehandelt werden kann. Der temperierbare (aktiv kühlbare) Gehäuseabschnitt wird durch wenigstens einen Rahmenabschnitt gebildet. Ebenso kann der Rahmen mit der wenigstens einen in den Hohlraum mündenden, verschließbaren Gasdurchführung sowie mit wenigstens einem Gasanschluss versehen sein, um den Hohlraum zu evakuieren und den Prozessraum während bestimmter Prozessschritte gezielt mit einer bestimmten Gasatmosphäre zu versehen.

Im montierten Zustand der Prozessbox ist der Hohlraum gasdicht ausgebildet, wobei beispielsweise der Deckel abnehmbar vom Rahmen ausgebildet sein kann, so dass der Prozessraum in einfacher Weise mit einem beschichteten Substrat beladen bzw. das prozessierte Substrat entladen werden kann. Bei einer besonders vorteilhaften Ausgestaltung der Prozessbox umfasst der Rahmen einen mit dem Boden fest verbundenen ersten Rahmenteil und einen mit dem Deckel fest verbundenen zweiten Rahmenteil, wobei die beiden Rahmenteile zur Formung des Hohlraums gasdicht miteinander fügbar sind.

Bei einer hierzu alternativen Ausgestaltung umfasst die Prozessbox ein Gehäuse mit einem einteiligen Gehäuseabschnitt mit einer Gehäuseöffnung, die durch ein vorzugsweise temperierbares (aktiv kühlbares) Verschlussteil beispielsweise seitlich gasdicht verschließbar ist. Die Trennwand steht beispielsweise parallel zum Verschlussteil.

Bei einer weiteren vorteilhaften Ausgestaltung der Erfindung weist der mit einer Kühleinrichtung koppelbare Gehäuseabschnitt eine in den Zwischenraum mündende, (beispielsweise durch ein Ventil) verschließbare Gasdurchführung zum Abziehen/Zuführen mindestens eines gasförmigen Stoffs (z.B. Evakuieren und Einleiten von Prozessgas) auf. Eine solche Gasdurchführung ist beispielsweise mit einem Gasanschluss, insbesondere einem Ventil zur Steuerung des Gasstroms, versehen. Durch die Kühlung des Gehäuseabschnitts können in der Vakuumtechnik übliche Kunststoffdichtungen und andere vergleichsweise kostengünstige Standardkomponenten zur Vakuumabdichtung der Vorrichtung verwendet werden. Insbesondere handelt es bei dem gekühlten Gehäuseabschnitt mit Gasdurchführung um das Verschlussteil zum Verschließen der Gehäuseöffnung.

Die Erfindung erstreckt sich weiterhin auf eine Anordnung zum Prozessieren eines beschichteten Substrats, mit einer wie oben beschrieben ausgebildeten Prozessbox, einem oder mehreren Heizstrahlern zum Erzeugen von elektromagnetischer Heizstrahlung, die benachbart zu dem wenigstens einen zur Wärmebehandlung dienenden Gehäuseabschnitt der Prozessbox angeordnet sind, sowie einer Temperier- bzw. Kühleinrichtung, welche mit dem wenigstens einen temperierbaren (aktiv kühlbaren) Gehäuseabschnitt zu dessen Temperierung (aktiven Kühlung) wärmetechnisch gekoppelt ist.

In obiger Anordnung sind die Heizstrahler in besonders vorteilhafter Weise so angeordnet, dass sich der Zwischenraum wenigstens teilweise, insbesondere vollständig, außerhalb eines gemeinsamen Strahlungsfelds der Heizstrahler befindet. Durch diese Maßnahme kann erreicht werden, dass sich ein Temperaturgradient (Temperaturbarriere) zwischen der Trennwand und dem temperieren (aktiv gekühlten) Gehäuseabschnitt der Prozessbox einstellt. Vorzugsweise ist der Temperaturgradient dergestalt, dass an der Trennwand eine voreinstellbare Prozesstemperatur zum Wärmebehandeln des beschichteten Substrats erreicht ist. Die Heizstrahler können zu diesem Zweck beispielsweise ausschließlich oberhalb und/oder unterhalb des Prozessraums angeordnet sein.

Darüber hinaus erstreckt sich die Erfindung auf ein Verfahren zum Prozessieren eines beschichteten Substrats in einer transportierbaren oder stationären Prozessbox, welche wie oben beschrieben ausgebildet ist. Das Verfahren umfasst die folgenden Schritte:
- Einbringen des beschichteten Substrats in einen Hohlraum der Prozessbox,
- gasdichtes Verschließen des Hohlraums der Prozessbox,
- Wärmebehandeln des beschichteten Substrats durch elektromagnetische Heizstrahlung, die von außerhalb der Prozessbox angeordneten Heizstrahlern erzeugt wird und auf wenigstens einen zur Wärmebehandlung dienenden Gehäuseabschnitt der Prozessbox auftrifft, wobei während der Wärmebehandlung wenigstens ein gasförmiger Stoff durch das beschichtete Substrat erzeugt wird,
- Temperieren bzw. Kühlen wenigstens eines Gehäuseabschnitts der Prozessbox während und gegebenenfalls nach der Wärmebehandlung,
- Hemmen der Diffusion des während der Wärmebehandlung erzeugten gasförmigen Stoffs zum temperierten bzw. gekühlten Gehäuseabschnitt durch eine mit einer oder mehreren Öffnungen versehenen Trennwand, welche zwischen dem beschichteten Substrat und dem temperierten bzw. gekühlten Gehäuseabschnitt angeordnet ist.

In dem Verfahren wird der wenigstens eine zur Wärmebehandlung dienende Gehäuseabschnitt der Prozessbox, auf welche die Heizstrahlung auftrifft, nicht temperiert bzw. gekühlt.

Bei einer vorteilhaften Ausgestaltung des Verfahrens wird ein zwischen der Trennwand und dem temperierten bzw. gekühlten Gehäuseabschnitt befindlicher Zwischenraum wenigstens teilweise, insbesondere vollständig, nicht von der elektromagnetischen Heizstrahlung bestrahlt.

Bei einer weiteren vorteilhaften Ausgestaltung des Verfahrens wird eine (gesamte) Öffnungsfläche der einen oder mehreren Öffnungen der Trennwand während der Wärmebehandlung durch Erwärmen der Trennwand auf maximal 50%, vorzugsweise maximal 30%, stärker bevorzugt maximal 10%, des Ausgangswerts (gesamte Öffnungsfläche vor der Wärmebehandlung) verringert.

Bei einer weiteren vorteilhaften Ausgestaltung des Verfahrens wird der Hohlraum der Prozessbox vor und/oder nach der Wärmebehandlung des beschichteten Substrats evakuiert und/oder mit einem Prozessgas (mit Unter- oder Überdruck) befüllt.

### Kurze Beschreibung der Zeichnungen

Die Erfindung wird nun näher erläutert, wobei Bezug auf die beigefügten Figuren genommen wird. Es zeigen in vereinfachter, nicht maßstäblicher Darstellung:
- Fig. 1: eine verallgemeinerte Querschnittsdarstellung einer erfindungsgemäßen Prozessbox zum Prozessieren eines beschichteten Substrats;
- Fig. 2: eine perspektivische Ansicht der Prozessbox von Fig. 1 mit einem stirnseitigen Verschlussteil;
- Fig. 3A-3C: anhand verschiedener Darstellungen ein Ausführungsbeispiel der erfindungsgemäßen Prozessbox;
- Fig. 4: eine Variante der Prozessbox von Fig. 3A-3C mit zwei fügbaren Rahmenteilen;
- Fig. 5A-5F: verschiedene Varianten einer temperaturgesteuerten Trennwand der erfindungsgemäßen Prozessbox.

In den Figuren ist eine in typischer Arbeitsposition horizontal orientierte Prozessbox veranschaulicht. Es versteht sich, dass die Prozessbox auch anders orientiert sein kann und die in der folgenden Beschreibung gemachten Lage- und Richtungsangaben sich lediglich auf die Darstellung der Prozessbox in den Figuren beziehen, wobei die Erfindung hierdurch nicht eingeschränkt sein soll.

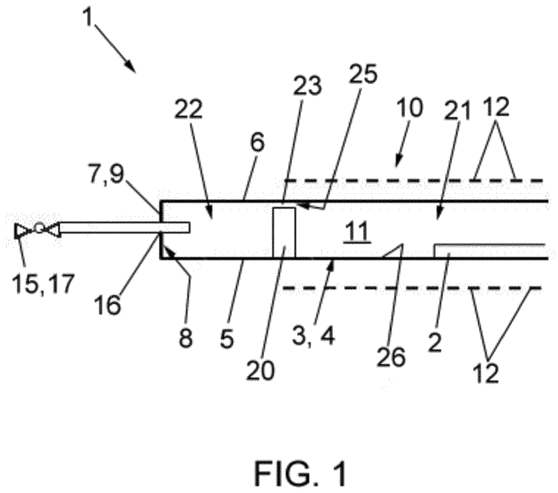

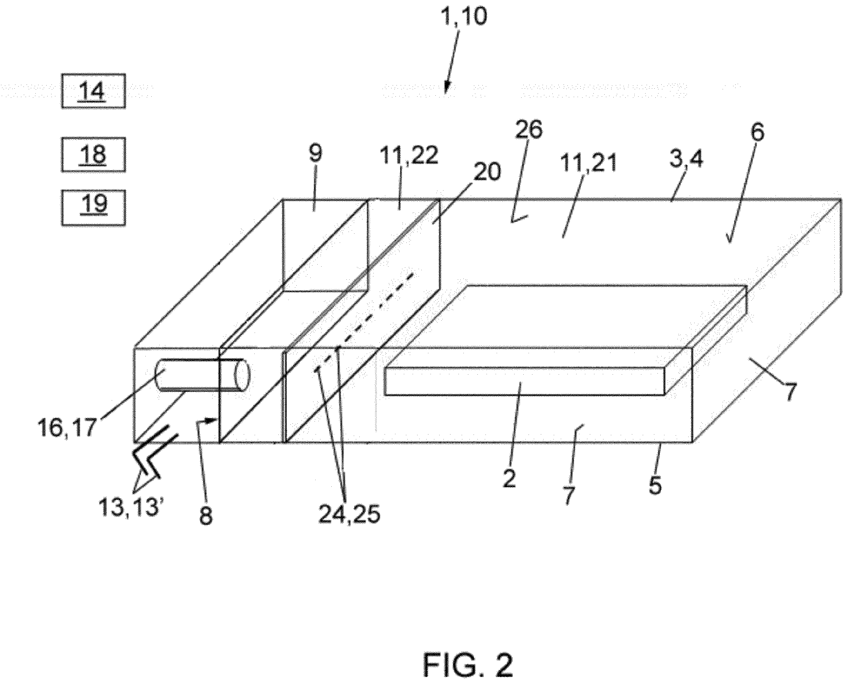

Seien zunächst Fig. 1 und 2 betrachtet, worin eine verallgemeinerte Schnittdarstellung einer erfindungsgemäßen Prozessbox 1 zum Prozessieren eines beschichteten Substrats 2 (Fig. 1), sowie eine perspektivische Ansicht einer solchen Prozessbox 1 mit einem stirnseitigen Verschlussteil 9 (Fig. 2) gezeigt ist. Die Prozessbox 1 dient zum Prozessieren eines einseitig beschichteten Substrats 2 beispielsweise zur Wärmebehandlung von Vorläuferschichten zur Umsetzung zu einem Verbindungshalbleiter, insbesondere eine Chalkopyritverbindung. Obgleich nur ein einziges Substrat 2 gezeigt ist, könnte die Prozessbox 1 gleichermaßen zum Prozessieren zweier oder mehrerer Substrate 2 eingesetzt werden.

Die Prozessbox 1 umfasst ein hier beispielsweise quaderförmiges Gehäuse 3 mit einer Gehäusewand 4, die sich aus einer Bodenwand 5, Deckwand 6 und umlaufenden Seitenwand 7 zusammensetzt. Die Gehäusewand 4 umgrenzt einen gasdichten bzw. evakuierbaren Hohlraum 11, der durch ein abnehmbares Verschlussteil 9 gasdicht verschließbar ist. Wie in Fig. 2 gezeigt, kann das Gehäuse 3 beispielsweise eine stirnseitige Gehäuseöffnung 8 aufweisen, die durch ein türartig aufsetzbares Verschlussteil 9, welches einen Teil der Seitenwand 7 bildet, verschließbar ist. Allgemein können die Gehäuseöffnung 8 und das zugehörige Verschlussteil 9 wahlfrei an einem beliebigen Wandabschnitt der Gehäusewand 4 platziert sein. Die Bodenwand 5 dient in einem mittleren Bereich als Auflagefläche für das Substrat 2, wobei gleichermaßen auch entsprechende Abstandshalter bzw. Stützelemente vorgesehen sein können.

Die Gehäusewand 4 der Prozessbox 1 kann aus einem gleichen Material oder voneinander verschiedenen Materialien bestehen. Typische Materialien sind Metall, Glas, Keramik, Glaskeramik carbonfaserverstärkte Kohlenstoffwerkstoffe oder Graphit. Wesentlich hierbei ist, dass die Deckwand 6 und die Bodenwand 5 jeweils so ausgebildet sind, dass eine Wärmebehandlung des beschichteten Substrats 2 durch von außen in Form von elektromagnetischer Heizstrahlung zugeführte Wärmeenergie möglich ist. Die Wärmeenergie kann in einer in Fig. 1 schematisch angedeuteten Anordnung 10 durch oberhalb der Deckwand 6 sowie unterhalb der Bodenwand 5 beispielsweise reihenförmig angeordnete Heizstrahler 12 zugeführt werden. Beispielsweise bestehen die Deckwand 6 und die Bodenwand 5 zu diesem Zweck aus einem Material, das transparent oder zumindest teiltransparent für die eingestrahlte elektromagnetische Strahlung ist, beispielsweise Glaskeramik. Die Deckwand 6 und die Bodenwand 5 können auch lediglich abschnittsweise aus einem solchen Material bestehen. Gleichermaßen ist es auch möglich, dass die Deckwand 6 und die Bodenwand 5 aus einem Material bestehen oder ein solches umfassen, welches geeignet ist, die elektromagnetische Strahlung zumindest teilweise, insbesondere vollständig, zu absorbieren, um selbst aufgeheizt zu werden, beispielsweise Graphit. In diesem Fall dienen die Deckwand 6 und die Bodenwand 5 als passiv geheizte, sekundäre Wärmequellen.

Wie in Fig. 2 erkennbar, ist die Gehäusewand 4, hier beispielsweise das Verschlussteil 9, mit zwei Kühlmittelanschlüssen 13, 13' versehen, die als Ein- bzw. Auslass für Kühlmittel in ein nicht näher dargestelltes, die umlaufende Seitenwand 7 wenigstens abschnittsweise, insbesondere vollständig, durchziehendes Kühlmittelleitungssystem dienen. Durch das eingeleitete Kühlmittel kann die umlaufende Seitenwand 7 wenigstens abschnittsweise auf eine voreinstellbare Temperatur temperiert bzw. in Bezug auf die Substrattemperaturen bei der Wärmebehandlung aktiv gekühlt werden. Die beiden Kühlmittelanschlüsse 13, 13' können zu diesem Zweck mit einer Temperier- bzw. Kühleinrichtung 14 zum Aufbereiten und Kühlen des Kühlmittels strömungstechnisch verbunden werden. Allgemein werden in der Prozessbox nur jene Gehäuseabschnitte temperiert bzw. gekühlt, welche nicht zur Wärmebehandlung des beschichteten Substrats 2 durch von außen in Form von elektromagnetischer Heizstrahlung zugeführte Wärmeenergie dienen, hier beispielsweise die umlaufende Seitenwand 7 oder zumindest ein Abschnitt hiervon. Im vorliegenden Beispiel wird lediglich das Verschlussteil 9 temperiert bzw. gekühlt. Als Kühlmittel kann beispielsweise Öl oder Wasser verwendet werden. Die Temperierung bzw. aktive Kühlung kann alternativ auch durch eine Kontaktkühlung (Wärmeleitung) durch Kontakt mit Kühlkörpern (beispielsweise Kühlplatten), ein Gebläse (Konvektionskühlung) oder kontaktlos durch beabstandete Kühlkörper (Strahlungskühlung) erreicht werden.

Das Gehäuse 3 umfasst weiterhin eine mit einem Ventil 15 versehene Gasdurchführung 16, die in den Hohlraum 11 mündet. Die Gasdurchführung 16 ist hier beispielsweise im stirnseitigen Verschlussteil 9 angeordnet. Über einen Gasanschluss 17 kann durch Anschluss an eine Abpumpeinrichtung 18 (z.B. Vakuumpumpe) der Hohlraum 11 evakuiert werden. Zudem kann der Gasanschluss 17 an eine Gasversorgungseinrichtung 19 angeschlossen werden, um den Hohlraum 11 durch Einleiten eines inerten Spülgases zu spülen oder mit einem reaktiven Prozessgas mit Unter- oder Überdruck zu füllen. Durch das Ventil 15 (beispielsweise ein Mehrwegeventil) kann die Gasdurchführung 16 wahlfrei geöffnet bzw. gasdicht verschlossen werden. Der Hohlraum 11 hat eine relativ geringe lichte Höhe, die beispielsweise im Bereich von 7 bis 12 mm liegt, um ein zügiges Evakuieren und effizientes Befüllen mit Prozessgas zu ermöglichen.

Der Hohlraum 11 ist durch eine leistenförmige Trennwand 20 in einen Prozessraum 21 und einen Zwischenraum 22 quasi-gasdicht unterteilt, wobei das beschichtete Substrat 2 ausschließlich im Prozessraum 21 aufgenommen ist. Die Gasdurchführung 16 mündet in den Zwischenraum 22. Die Trennwand 20 ist mit einer oder mehreren Öffnungen bzw. Durchbrechungen versehen, durch welche der Prozessraum 21 mit dem Zwischenraum 22 strömungstechnisch verbunden ist.

Wie in der Vertikalschnittdarstellung von Fig. 1 erkennbar, reicht die Trennwand 20, welche sich in vertikaler Richtung von der Bodenwand 5 in Richtung zur Deckwand 6 erstreckt, nicht ganz bis zur Deckwand 6 heran, so dass ein Spalt 23 als Öffnung der Trennwand 20 verbleibt. In Fig. 2 ist eine Variante gezeigt, bei welcher sich die Trennwand 20 bis zur Deckwand 6 erstreckt und mit einer Mehrzahl, etwa mittig in einer Reihe angeordneten, horizontalen Schlitzen 24 als Öffnungen versehen ist. Durch den Spalt 23 bzw. Schlitze 24 ist der Prozessraum 21 mit dem Zwischenraum 22 strömungstechnisch verbunden, so dass ein wechselseitiger Gasaustausch möglich ist, jedoch aufgrund der geringen vertikalen Abmessung bzw. Höhe des Spalts 23 bzw. Schlitze 24 gehemmt ist. Die Trennwand 20 wirkt somit als Diffusions- bzw. Dampfbarriere zwischen Prozessraum 21 und Zwischenraum 22.

Die Eigenschaft der Trennwand 20 als Diffusions- bzw. Dampfbarriere zu wirken, beruht auf der Druckabhängigkeit der freien Weglänge: bei nahezu Normaldruck (700-1000mbar) ist die Diffusion durch die vergleichsweise kleine(n) Öffnung(en) der Trennwand 20 gehemmt. Wird der Zwischenraum 22 dagegen auf Drücke im Vorvakuumbereich (10-1000pbar) abgepumpt, ist die freie Weglänge stark erhöht und die Trennwand 20 stellt nur noch eine schwache Diffusionsbarriere für den Gasaustausch dar. Der Prozessraum 21 kann somit durch die Trennwand 20 hindurch abgepumpt werden und Prozessgas kann nach dem Abpumpen durch Einlass in den Zwischenraum 22 auch in den Prozessraum 21 strömen. Andererseits kann durch die Trennwand 20 der Partialdruck von leicht flüchtigen Chalkogenkomponenten wie Selen oder Schwefel im Prozessraum 21, die während der Wärmebehandlung vom beschichteten Substrat 2 ausdiffundieren/verdampfen, während der Wärmebehandlung des Substrats 2 zumindest weitestgehend konstant gehalten werden. Die Trennwand 20 wirkt somit beispielsweise als Selenbarriere bei der Wärmebehandlung eines Substrats 2.

Allgemein ist eine (gemeinsame) Öffnungsfläche 25 des Spalts 23 bzw. Schlitze 24 so bemessen, dass während der Wärmebehandlung des Substrats 2 ein Massenverlust eines durch die Wärmebehandlung des beschichteten Substrats 2 im Prozessraum 21 erzeugten gasförmiges Stoffs aus dem Prozessraum 21 weniger als 50%, vorzugsweise weniger als 20%, stärker bevorzugt weniger als 10%, der Masse des im Prozessraum 21 erzeugten gasförmigen Stoffs beträgt. Zu diesem Zweck ist die Trennwand 20 so ausgebildet, dass ein Flächenverhältnis, gebildet aus der Öffnungsfläche 25 geteilt durch eine innere Oberfläche bzw. Innenfläche 26 des Prozessraums 21, im Bereich von 5 x 10⁻⁵ bis 5 x 10⁻⁴ liegt.

Beispielsweise hat die Innenfläche 26 des Prozessraums 21 eine Größe von ca. 1,2 m². Eine mittlere Spalthöhe des Spalts 23 liegt beispielsweise im Bereich von 50 bis 100 µm, entsprechend einer Öffnungsfläche 25 im Bereich von 2 bis 5 cm². Die Trennwand 20 hat beispielsweise eine Höhe von 9 mm. Aus diesen Werten ergibt sich ein Flächenverhältnis von 1,5 x 10⁻⁴.

Durch die als Dampf- bzw. Diffusionsbarriere dienende Trennwand 20 kann eine Diffusion von während der Wärmebehandlung im Prozessraum 21 entstehenden flüchtigen Komponenten in den Zwischenraum 22 zumindest weitestgehend unterbunden werden, so dass eine Kondensation der flüchtigen Komponenten an der temperierten (aktiv gekühlten) Seitenwand 7, hier speziell Verschlussteil 9, verhindert wird. Die Prozessatmosphäre im Prozessraum 21 kann somit zumindest annähernd konstant gehalten werden.

Wie in Fig. 2 veranschaulicht, befindet sich der Zwischenraum 22 zumindest teilweise, insbesondere vollständig, außerhalb eines (gemeinsamen) Strahlungsfelds der Heizstrahler 12, so dass sich während der Wärmebehandlung ein Temperaturgradient im Zwischenraum 22 von der Trennwand 20 zur temperierten (aktiven gekühlten) Seitenwand 7, hier speziell Verschlussteil 9, ausbildet. Dieser Temperaturgradient dient als "Temperaturbarriere" zum Schutz von vakuumfähigen Komponenten der Prozessbox 1 vor hoher thermischer Belastung. Zu diesem Zweck sind die Heizstrahler 12 ausschließlich ober- bzw. unterhalb des Prozessraums 21 vor bzw. bis hin zur Trennwand 20 angeordnet. Die Heizstrahler 12 enden jeweils zumindest einige Zentimeter vor dem Zwischenraum 22 oder Trennwand 20. Andererseits sind die Heizstrahler 12 so angeordnet, dass sich ein ansteigender Temperaturgradient derart ausbildet, dass eine gewünschte Prozesstemperatur zum Wärmebehandeln des beschichteten Substrats 2 ausgehend von der Seitenwand 7, speziell Verschlussteil 9, hin zur Trennwand 20 vor oder wenigstens auf Höhe der Trennwand 20 erreicht wird, um eine ausreichende Umsetzung der Vorläuferschichten des Substrats 2 zum Verbindungshalbleiter sicherzustellen.

In der in Fig. 1 veranschaulichten allgemeinen Ausführungsform können die Trennwand 20, der Zwischenraum 22 und der(die) temperierbare(n) bzw. kühlbare(n) Abschnitt(e) der Seitenwand 7 seitlich in einer Richtung, in zwei Richtungen oder umlaufend (Rahmen) ausgestaltet sein. In der Ausführungsform von Fig. 2 sind Trennwand 20, Zwischenraum 22 und der temperierbare Abschnitt der Seitenwand 7 (Verschlussteil 9) nur in einer Raumrichtung ausgeführt.

Das Substrat 2 besteht beispielsweise aus Glas mit einer Dicke im Bereich von 1 mm bis 4 mm, insbesondere 2 mm bis 3 mm. Das Substrat 2 ist mit einem nicht näher dargestellten Schichtenaufbau versehen, welcher beispielsweise aus Vorläuferschichten eines Absorbers (z.B. Chalkopyrit- oder Kesteritverbindung) besteht, die einer RTP-Wärmebehandlung unterzogen werden müssen. Beispielsweise handelt es sich bei dem Schichtenaufbau um eine Abfolge der Schichten Siliziumnitrid/Molybdän/Kupfer-Indium-Gallium/Selen. Beispielsweise hat die Siliziumnitrid-Schicht eine Dicke im Bereich von 50 nm bis 300 nm, die Molybdän-Schicht eine Dicke im Bereich von 200 nm bis 700 nm, die Kupfer-Indium-Gallium-Schicht eine Dicke im Bereich von 300 nm bis 1000 nm und die Selen-Schicht eine Dicke im Bereich von 500 nm bis 2000 nm.

Die Prozessbox 1 kann in einfacher Weise automatisiert montiert und durch die Gehäuseöffnung 8 be- bzw. entladen werden. Die Trennwand 20 muss dabei jeweils beim Öffnen und Schließen so bewegt werden, dass das Substrat 2 hinein gebracht werden kann.

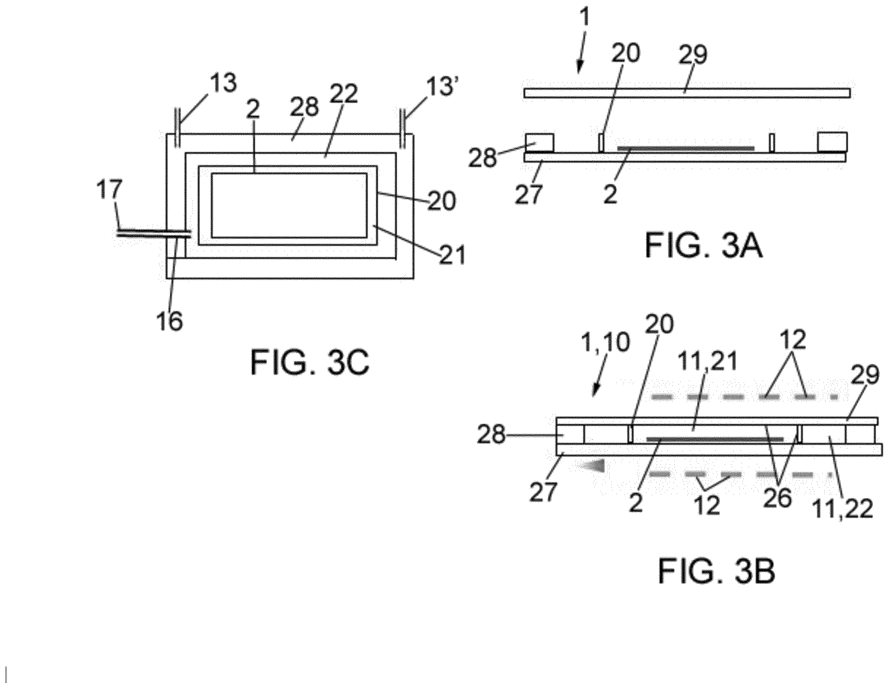

Unter Bezugnahme auf die Fig. 3A-3C wird anhand verschiedener Darstellungen ein weiteres Ausführungsbeispiel der in allgemeiner Form in Fig. 1 veranschaulichten Prozessbox 1 beschrieben.

Demnach umfasst die Prozessbox 1 eine Bodenplatte 27, auf welche in einem Randbereich ein umlaufend geschlossener Rahmen 28 lose, aber abdichtbar, aufgesetzt ist. Denkbar wäre es, den Rahmen 28 mit der Bodenplatte 27 fest zu verbinden. Wie in den Vertikalschnittdarstellungen von Fig. 3A und 3B gut erkennbar, dient die Bodenplatte 27 in einem mittleren Bereich als Auflage für das Substrat 2, wobei gleichermaßen entsprechende Abstandshalter bzw. Stützelemente vorgesehen sein können. Auf den Rahmen 28 ist eine ebene Deckplatte 29 lose aufgesetzt. Durch Abnehmen der Deckplatte 29 vom Rahmen 28 kann die Prozessbox 1 in einfacher Weise mit dem beschichteten Substrat 2 insbesondere automatisiert beladen bzw. das prozessierte Substrat 2 entnommen werden. Fig. 3A zeigt die offene Prozessbox 1 mit abgehobener Deckplatte 29, Fig. 3B die geschlossene Prozessbox 1 mit auf den Rahmen 28 aufgesetzter Deckplatte 29.

In der Prozessbox 1 sind Bodenplatte 27, Rahmen 28 und Deckplatte 29 stapelförmig über- bzw. untereinander angeordnet und umgrenzen gemeinsam den gasdichten bzw. evakuierbaren Hohlraum 11. Der Hohlraum 11 ist durch die in Entsprechung zum Rahmen 28 umlaufend geschlossen ausgebildete, leistenförmige Trennwand 20 in den (inneren) Prozessraum 21 und den umlaufenden (äußeren) Zwischenraum 22 quasi-gasdicht unterteilt. Der Zwischenraum 22 umgibt den Prozessraum 21. Analog zu Fig. 1 erstreckt sich die leistenförmige Trennwand 20 in vertikaler Richtung von der Bodenplatte 27 in Richtung zur Deckplatte 29, wobei ein enger Spalt 23 zwischen Trennwand 20 und Deckplatte 29 verbleibt. Durch den Spalt 23 ist der Prozessraum 21 mit dem Zwischenraum 22 strömungstechnisch verbunden, so dass ein wechselseitiger Gasaustausch möglich ist, wobei die Trennwand 20 jedoch als Diffusions- bzw. Dampfbarriere wirkt. Auf die diesbezüglichen Ausführungen zu Fig. 1 wird verwiesen.

Wie in Fig. 3C erkennbar, mündet die mit dem Ventil 15 versehene Gasdurchführung 16 durch den Rahmen 28 in den Zwischenraum 22, um den Hohlraum 11 zu evakuieren, mit einem inerten Spülgas (z.B N₂) zu spülen und mit einem Prozessgas zu befüllen. Das durch die Gasdurchführung 16 eingeleitete Prozessgas kann beispielsweise reaktive Gase wie H₂S, H₂Se, S-Dampf, Se-Dampf oder H₂ sowie Inertgase wie N₂, He oder Ar enthalten.

Wie weiterhin in Fig. 3C erkennbar, ist der Rahmen 28 mit den beiden Kühlmittelanschlüssen 13, 13' versehen, die als Ein- bzw. Auslass für Kühlmittel in ein nicht näher dargestelltes, den Rahmen 28 weitläufig durchziehendes Kühlmittelleitungssystem dienen. Durch das in den Rahmen 28 eingeleitete Kühlmittel kann der Rahmen 28 während und falls gewünscht auch nach der Wärmebehandlung des Substrats 2 temperiert (aktiv gekühlt) werden. Die beiden Kühlmittelanschlüsse 13, 13' sind zu diesem Zweck mit der Kühleinrichtung 14 zum Aufbereiten und Kühlen des Kühlmittels strömungstechnisch verbunden. Der Rahmen 28 besteht vorzugsweise aus einem Material mit einer hohen Wärmeleitfähigkeit, beispielsweise aus einem metallischen Material, insbesondere Edelstahl.

Die Bodenplatte 27 und die Deckplatte 29 sind jeweils so ausgebildet sind, dass eine Wärmebehandlung des beschichteten Substrats 2 durch oberhalb bzw. unterhalb der Prozessbox 1 in Form von elektromagnetischer Heizstrahlung zugeführte Wärmeenergie möglich ist. Auf die diesbezüglichen Ausführungen zu Fig. 1 wird verwiesen. Beispielsweise bestehen Bodenplatte 27 und Deckplatte 29 zu diesem Zweck aus Glaskeramik.

Durch die als Dampf- bzw. Diffusionsbarriere dienende Trennwand 20 kann eine Diffusion von während der Wärmebehandlung im Prozessraum 21 entstehenden flüchtigen Komponenten in den Zwischenraum 22 zumindest weitestgehend unterbunden werden, so dass eine Kondensation der flüchtigen Komponenten am temperierten (aktiv gekühlten) Rahmen 28 verhindert wird. Die Prozessatmosphäre im Prozessraum 21 kann somit zumindest annähernd konstant gehalten werden.

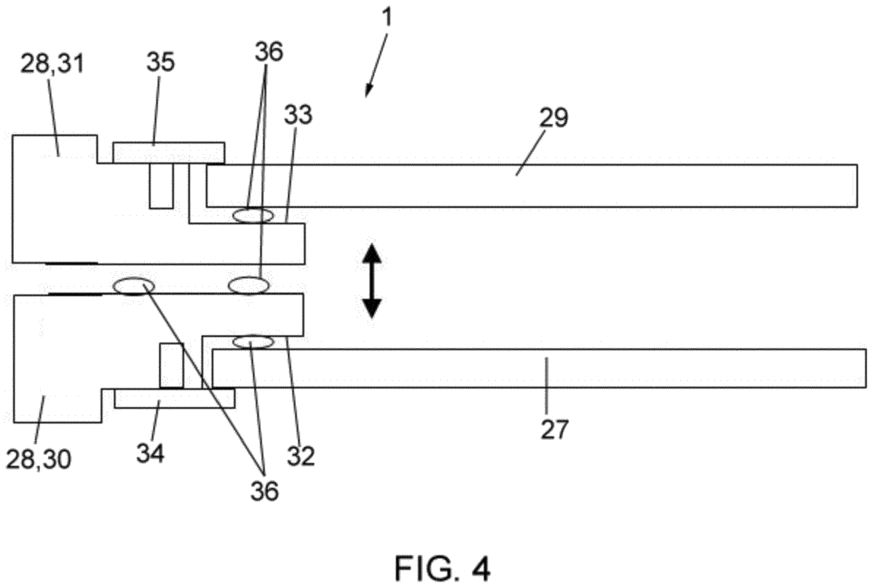

In Fig. 4 ist eine Variante der Prozessbox 1 von Fig. 3A-3C dargestellt. Um unnötige Wiederholungen zu vermeiden, werden lediglich die Unterschiede zu Fig. 3A-3C dargestellt und ansonsten wird auf die diesbezüglichen Ausführungen Bezug genommen. Demnach unterscheidet sich die Prozessbox 1 dahingehend, dass der Rahmen 28 aus zwei Rahmenteilen 30, 31 besteht, die gasdicht miteinander gefügt werden können. So ist ein unterer, erster Rahmenteil 30 vorgesehen, der über eine erste Anlagefläche 32 verfügt, gegen die die Bodenplatte 27 durch ein erstes Klemmelement 34 zur festen Verbindung geklemmt ist. In Entsprechung ist ein oberer, zweiter Rahmenteil 31 vorgesehen, der über eine zweite Anlagefläche 33 verfügt, gegen die die Deckplatte 29 durch ein zweites Klemmelement 35 zur festen Verbindung geklemmt ist. Wie durch den Doppelpfeil angedeutet, kann das zweite Rahmenteil 31 vom ersten Rahmenteil 30 abgehoben werden, um die Prozessbox 1 mit dem Substrat 2 zu beladen oder das prozessierte Substrat 2 herauszunehmen. Andererseits können die beiden Rahmenteile 30, 31 gasdicht gefügt werden, wobei durch Dichtungselemente 36 die geforderte Gasdichtigkeit sichergestellt ist. Die Prozessbox 1 zeichnet sich durch eine besondere einfache, automatisierbare Be- und Entladbarkeit aus.

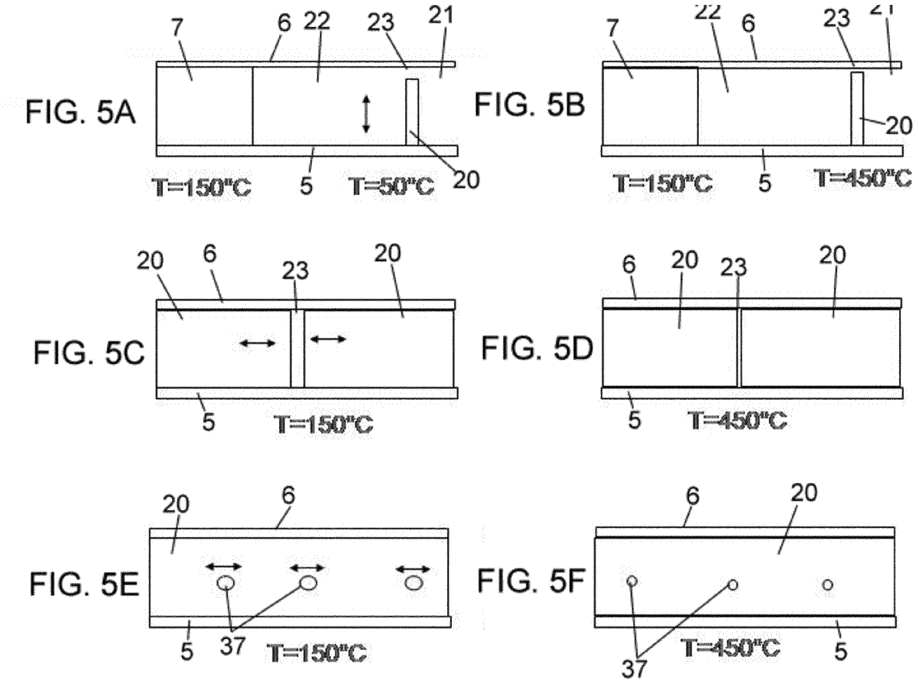

Es wird nun Bezug auf Fig. 5A-5F genommen, worin verschiedene Varianten der Trennwand 20 der Prozessbox 1 veranschaulicht sind. Es handelt sich jeweils um eine temperaturgesteuerte Trennwand 20, welche zu diesem Zweck aus einem Material besteht, das einen solchen Wärmeausdehnungskoeffizienten hat, dass sich eine gesamte Öffnungsfläche 25 der jeweiligen Öffnungen bzw. Durchbrechungen durch Erwärmen der Trennwand 20 während der Wärmebehandlung auf maximal 50%, vorzugsweise maximal 30%, stärker bevorzugt maximal 10%, des Ausgangswerts (gesamte Öffnungsfläche 25 vor der Wärmebehandlung) verringert. Die Trennwand 20 besteht zu diesem Zweck aus einem Material mit einem Wärmeausdehnungskoeffizienten von mehr als 5 x 10⁻⁶ K⁻¹. Beispiele hierfür sind bestimmte Glaskeramiken mit einem Wärmeausdehnungskoeffizienten von 9 x 10⁻⁶ K⁻¹, Aluminiumoxid (Al₂O₃) mit einem Wärmeausdehnungskoeffizienten im Bereich von 6,5 x 10⁻⁶ K⁻¹ bis 9 x 10⁻⁶ K⁻¹, Zirkonoxid und Magnesiumoxid mit einem Wärmeausdehnungskoeffizienten im Bereich von 10 x 10⁻⁶ K⁻¹ bis 13 x 10⁻⁶ K⁻¹. Das Material der Trennwand 20 muss zudem temperaturbeständig und korrosionsresistent sein.

In Fig. 5A und 5B ist die als vertikale Leiste ausgebildete Trennwand 20 der Prozessbox 1 jeweils in einer Vertikalschnittdarstellung gezeigt. Demnach reicht die Trennwand 20 nicht bis zur Deckwand 6 bzw. Deckplatte 29, so dass der Spalt 23 als Öffnung zur strömungstechnischen Verbindung von Prozessraum 21 und Zwischenraum 22 verbleibt. In Fig. 5A ist eine Situation gezeigt, bei der die Seitenwand 7 bzw. der Rahmen 28 auf eine Temperatur T=150°C temperiert ist, während die Trennwand 20 eine Temperatur T=50°C hat. Das Material der Trennwand 20 ist relativ kalt, der Spalt 23 weit offen. Die vertikale Abmessung bzw. mittlere Spalthöhe (lichte Weite) des Spalts 23 liegt im Bereich von 50 bis 100 µm bei einer Höhe der Trennwand 20 von ca. 10 mm. Bei Erwärmung dehnt sich das Material der Trennwand 20 relativ stark aus, wobei sich die mittlere Spalthöhe verringert (Fig. 5B). Beispielsweise erhält man bei einer Erwärmung der Trennwand 20 auf eine Temperatur T=450°C (Temperaturdifferenz 400°C) eine Änderung der vertikalen Abmessung der Trennwand 20 von ca. 40 µm, so dass sich die mittlere Spalthöhe des Spalts 23 auf einen Wert im Bereich von 10 bis 50 µm, also maximal 50% des Ausgangswerts, verringert.

In den Fig. 5C und 5D ist anhand einer Aufsicht auf die Trennwand 20 eine Variante gezeigt. Um unnötige Wiederholungen zu vermeiden, werden lediglich die Unterschiede zu Fig. 5A und 5B erläutert und ansonsten wird auf die dortigen Ausführungen Bezug genommen. Demnach erstreckt sich die leistenförmige Trennwand 20 von der Bodenwand 5 bzw. Bodenplatte 27 zur Deckwand 6 bzw. Deckplatte 29, wobei ein oder mehrere vertikale Spalten 23 in Form von Durchbrechungen der Trennwand 20 ausgebildet sind. Die in horizontaler Richtung sich bemessende Spaltbreite liegt im Bereich von 50 bis 100 µm (Fig. 5C). Durch eine im Vergleich zur Höhe von 10 mm größere Abmessung der Trennwandbereiche zwischen zwei Spalten 23 kann bei Erwärmung der Trennwand 20 auf eine Temperatur von beispielsweise T=450°C ein relativ großer Hub erreicht werden, welcher beispielsweise mehrere 100 µm betragen kann. Insbesondere kann hierbei die gesamte Öffnungsfläche der Spalte 23 auf beispielsweise maximal 50% des Ausgangswerts reduziert werden.

In den Fig. 5E und 5F ist anhand einer Aufsicht auf die Trennwand 20 eine weitere Variante gezeigt. Um unnötige Wiederholungen zu vermeiden, werden wiederum lediglich die Unterschiede zu Fig. 5A und 5B erläutert und ansonsten wird auf die dortigen Ausführungen Bezug genommen. Demnach ist anstelle eines Spaltes 23 eine Mehrzahl Rundlöcher 37 vorgesehen, die jeweils in Form von Durchbrechungen der Trennwand 20 ausgebildet sind. Ausgehend von einer Situation, bei welcher die Temperatur der Trennwand 20 beispielsweise T=150°C beträgt (Fig. 5E), kann durch eine Erwärmung der Trennwand 20 auf eine Temperatur von beispielsweise T=450°C eine Verringerung des Öffnungsdurchmessers der Rundlöcher 37 erreicht werden (Fig. 5F). Insbesondere kann hierbei die gesamte Öffnungsfläche der Rundlöcher 37 auf beispielsweise maximal 50% des Ausgangswerts reduziert werden.

Die erfindungsgemäße Prozessbox 1 ermöglicht eine Prozessierung von Substraten 2 in einer Anlage, bei der die Prozessstationen nicht als vakuumfähige Kammern ausgebildet werden müssen, so dass die Investitionskosten erheblich vermindert sind. Zudem kann ein erhöhter Verschleiß von Anlagenkomponenten durch hohe Temperaturen und korrosive Gase kann vermieden werden. In der Prozessbox 1 kann in kontrollierter Weise eine Umsetzung von Precursor-Materialien zum Absorber während einer RTP-Wärmebehandlung erfolgen. Die Prozessbox 1 unterstützt die Herstellung beschichteter Substrate 2 für Dünnschichtsolarmodule mit hohen Güte- bzw. Qualitätsanforderungen.

### Bezugszeichenliste

- 1: Prozessbox
- 2: Substrat
- 3: Gehäuse
- 4: Gehäusewand
- 5: Bodenwand
- 6: Deckwand
- 7: Seitenwand
- 8: Gehäuseöffnung
- 9: Verschlussteil
- 10: Anordnung
- 11: Hohlraum
- 12: Heizstrahler
- 13, 13': Kühlmittelanschluss
- 14: Kühleinrichtung
- 15: Ventil
- 16: Gasdurchführung
- 17: Gasanschluss
- 18: Abpumpeinrichtung
- 19: Gasversorgungseinrichtung
- 20: Trennwand
- 21: Prozessraum
- 22: Zwischenraum
- 23: Spalt
- 24: Schlitz
- 25: Öffnungsfläche
- 26: Innenfläche
- 27: Bodenplatte
- 28: Rahmen
- 29: Deckplatte
- 30: erster Rahmenteil
- 31: zweiter Rahmenteil
- 32: erste Anlagefläche
- 33: zweite Anlagefläche
- 34: erstes Klemmelement
- 35: zweites Klemmelement
- 36: Dichtungselement
- 37: Rundloch

## Patentansprüche

1. Prozessbox (1) zum Prozessieren eines beschichteten Substrats (2), mit den folgenden Merkmalen:
- ein gasdicht verschließbares Gehäuse (3), das einen Hohlraum (11) umgrenzt,
- das Gehäuse (3) weist wenigstens einen mit einer Kühleinrichtung (14) zu dessen Kühlung koppelbaren ersten Gehäuseabschnitt (7, 9; 28) auf,
- das Gehäuse (3) umfasst wenigstens einen zweiten Gehäuseabschnitt (5, 6; 27, 29), der so ausgebildet ist, dass das Substrat (2) durch auftreffende elektromagnetische Heizstrahlung wärmebehandelbar ist, wobei der wenigstens eine zweite Gehäuseabschnitt (5, 6; 27, 29) vom wenigstens einen ersten Gehäuseabschnitt (7, 9; 28) verschieden ist,
- das Gehäuse (3) ist mit wenigstens einer in den Hohlraum (11) mündenden, verschließbaren Gasdurchführung (16) zum Evakuieren und Einleiten von Prozessgas in den Hohlraum (11) versehen,
- der Hohlraum (11) ist durch wenigstens eine Trennwand (20) in einen Prozessraum (21) zum Aufnehmen des Substrats (2) und einen Zwischenraum (22) unterteilt, wobei die Trennwand (20) über eine oder mehrere Öffnungen (23, 24, 37) verfügt, **dadurch gekennzeichnet, dass** die Trennwand zwischen dem Substrat (2) und dem mit der Kühleinrichtung (14) koppelbaren ersten Gehäuseabschnitt (7, 9; 28) angeordnet ist, wobei die Trennwand (20) so ausgebildet ist, dass während der Wärmebehandlung ein Massenverlust eines durch die Wärmebehandlung des beschichteten Substrats (2) erzeugten gasförmiges Stoffs aus dem Prozessraum (21) weniger als 50%, vorzugsweise weniger als 20%, stärker bevorzugt weniger als 10%, beträgt, wobei die Trennwand (20) so ausgebildet ist, dass ein Flächenverhältnis, gebildet aus einer gesamten Öffnungsfläche (25) der einen oder mehreren Öffnungen (23, 24, 37) geteilt durch eine Innenfläche (26) des Prozessraums (21), im Bereich von 5 x 10⁻⁵ bis 5 x 10⁻⁴ liegt.

2. Prozessbox (1) nach Anspruch 1, bei welcher die Trennwand (20) ein Material enthält, das einen solchen Wärmeausdehnungskoeffizienten hat, dass sich eine gesamte Öffnungsfläche (25) der einen oder mehreren Öffnungen (23, 24, 37) durch Erwärmen der Trennwand (20) während der Wärmebehandlung auf maximal 50%, vorzugsweise maximal 30%, stärker bevorzugt maximal 10%, einer gesamten Öffnungsfläche (25) vor der Wärmebehandlung verringert.

3. Prozessbox (1) nach einem der Ansprüche 1 bis 2, bei welcher die Trennwand (20) ein Material mit einem Wärmeausdehnungskoeffizienten von mehr als 5 x 10⁻⁶ K⁻¹ enthält.

4. Prozessbox (1) nach einem der Ansprüche 1 bis 3, bei welcher das Gehäuse (3) einen Boden (27), einen Deckel (29), sowie einen Boden (27) und Deckel (29) miteinander verbindenden Rahmen (28) umfasst, wobei der mit einer Kühleinrichtung (14) koppelbare Gehäuseabschnitt durch wenigstens einen Rahmenabschnitt (28) gebildet ist.

5. Prozessbox (1) nach Anspruch 4, bei welcher der Rahmen (28) einen mit dem Boden (27) fest verbundenen ersten Rahmenteil (30) und einen mit dem Deckel (29) fest verbundenen zweiten Rahmenteil (31) umfasst, wobei die beiden Rahmenteile (30, 31) zur Formung des Hohlraums (11) gasdicht miteinander fügbar sind.

6. Prozessbox (1) nach einem der Ansprüche 1 bis 5, bei welcher das Gehäuse (3) umfasst:
- einen einteiligen Gehäuseabschnitt (5-7), der den Hohlraum (11) umgrenzt, mit einer Gehäuseöffnung (6),
- ein Verschlussteil (9) zum gasdichten Verschließen der Gehäuseöffnung (6).

7. Prozessbox (1) nach Anspruch 6, bei welcher der mit einer Kühleinrichtung (14) koppelbare Gehäuseabschnitt das Verschlussteil (9) enthält.

8. Anordnung (10) zum Prozessieren eines beschichteten Substrats (2), welche umfasst:
- eine Prozessbox (1) nach einem der Ansprüche 1 bis 7,
- einen oder mehrere Heizstrahler (12) zum Erzeugen von elektromagnetischer Heizstrahlung, die benachbart zu dem wenigstens einen zur Wärmebehandlung dienenden zweiten Gehäuseabschnitt (5, 6; 27, 29) der Prozessbox (1) angeordnet sind,
- eine Kühleinrichtung (14), welche mit dem wenigstens einen ersten Gehäuseabschnitt (7, 9; 28) zu dessen Kühlung gekoppelt ist.

9. Anordnung (10) nach Anspruch 8, bei welcher die Heizstrahler (12) so angeordnet sind, dass sich der Zwischenraum (22) wenigstens teilweise, insbesondere vollständig, außerhalb eines gemeinsamen Strahlungsfelds der Heizstrahler (12) befindet.

10. Anordnung (10) nach Anspruch 9, bei welcher die Heizstrahler (12) ausschließlich oberhalb und/oder unterhalb des Prozessraums (21) angeordnet sind.

11. Verfahren zum Prozessieren eines beschichteten Substrats (2) in einer transportierbaren oder stationären Prozessbox (1) nach einem der Ansprüche 1 bis 7, welches die folgenden Schritte umfasst:
- Einbringen des beschichteten Substrats (2) in einen Hohlraum (11) der Prozessbox (1),
- gasdichtes Verschließen des Hohlraums (11) der Prozessbox (1),
- Wärmebehandeln des beschichteten Substrats (2) durch elektromagnetische Heizstrahlung, die von außerhalb der Prozessbox (1) angeordneten Heizstrahlern (12) erzeugt wird und auf den wenigstens einen zur Wärmebehandlung dienenden zweiten Gehäuseabschnitt (5, 6; 27, 29) der Prozessbox (1) auftrifft, wobei während der Wärmebehandlung wenigstens ein gasförmiger Stoff durch das beschichtete Substrat (2) erzeugt wird,
- Kühlen des wenigstens eine ersten Gehäuseabschnitts (7, 9; 28) der Prozessbox (1) während und gegebenenfalls nach der Wärmebehandlung,
- Hemmen der Diffusion des während der Wärmebehandlung erzeugten gasförmigen Stoffs zum gekühlten Gehäuseabschnitt (7, 9; 28) durch eine mit einer oder mehreren Öffnungen (23, 24, 37) versehene Trennwand (20), welche zwischen dem beschichteten Substrat (2) und dem gekühlten Gehäuseabschnitt (7, 9; 28) angeordnet ist.

12. Verfahren nach Anspruch 11, bei welchem ein zwischen der Trennwand (20) und dem gekühlten Gehäuseabschnitt (7, 9; 28) befindlicher Zwischenraum (22) wenigstens teilweise, insbesondere vollständig, nicht von der elektromagnetischen Heizstrahlung bestrahlt wird.

13. Verfahren nach einem der Ansprüche 12 oder 13, bei welchem eine gesamte Öffnungsfläche (25) der einen oder mehreren Öffnungen (23, 24, 37) der Trennwand (20) während der Wärmebehandlung durch Erwärmen der Trennwand auf maximal 50%, vorzugsweise maximal 30%, stärker bevorzugt maximal 10%, des Ausgangswerts vor der Wärmebehandlung verringert wird.

14. Verfahren nach einem der Ansprüche 11 bis 13, bei welchem der Hohlraum (11) der Prozessbox (1) vor und/oder nach der Wärmebehandlung des beschichteten Substrats (2) evakuiert und/oder mit einem Prozessgas befüllt wird.

## Claims

1. Process box (1) for processing a coated substrate (2), with the following features:
- a gas-tightly sealable housing (3), which encloses a hollow space (11),
- the housing (3) has at least one first housing section (7, 9; 28) coupleable to a cooling device (14) for its cooling
- the housing (3) comprises at least one second housing section (5, 6; 27, 29), which is implemented such that the substrate (2) is heat treatable by incident electromagnetic thermal radiation, wherein the at least one second housing section (5, 6; 27, 29) is different from the at least one first housing section (7, 9, 28),
- the housing (3) is provided with at least one sealable gas passage (16) opening into the hollow space (11) for evacuating and introducing process gas into the hollow space (11),
- the hollow space (11) is divided by at least one separating wall (20) into a process space (21) for accommodating the substrate (2) and an intermediate space (22), wherein the separating wall (20) has one or a plurality of openings (23, 24, 37), **characterized in that** the separating wall is arranged between the substrate (2) and the first housing section (7, 9; 28) coupleable to the cooling device (14),
wherein the separating wall (20) is implemented such that during the heat treatment a mass loss of a gaseous substance generated by the heat treatment of the coated substrate (2) out of the process space (21) is less than 50%, preferably less than 20%, more preferably less than 10%, wherein the separating wall (20) is implemented such that an area ratio, formed from a total opening area (25) of the one or a plurality of openings (23, 24, 37) divided by an inner surface (26) of the process space (21), is in the range from 5 x 10⁻⁵ to 5 x 10⁻⁴.

2. Process box (1) according to claim 1, wherein the separating wall (20) contains a material, which has such a coefficient of thermal expansion, that a total opening area (25) of the one or a plurality of openings (23, 24, 37) is reduced by heating the separating wall (20) during the heat treatment to a maximum of 50%, preferably a maximum of 30%, more preferably a maximum of 10%, of a total opening area (25) before the heat treatment.

3. Process box (1) according to one of claims 1 through 2, wherein the separating wall (20) contains a material with a coefficient of thermal expansion of more than 5 x 10⁻⁶ K⁻¹.

4. Process box (1) according to one of claims 1 through 3, wherein the housing (3) comprises a bottom (27), a cover (29), as well as a frame (28) connecting bottom (27) and cover (29) to each other, wherein the housing section coupleable to a cooling device (14) is formed by at least one frame section (28).

5. Process box (1) according to claim 4, wherein the frame (28) comprises comprises a first frame part (30) fixedly connected to the bottom (27) and a second frame part (31) fixedly connected to the cover (29), wherein the two frame parts (30, 31) are gas-tightly joinable to each other to form the hollow space (11).

6. Process box (1) according to one of claims 1 through 5, wherein the housing (3) comprises:
- a one-piece housing section (5-7), which encloses the hollow space (11), with a housing opening (6),
- a seal (9) for the gas-tight sealing of the housing opening (6).

7. Process box (1) according to claim 6, wherein the housing section coupleable to a cooling device (14) includes the seal (9).

8. Assembly (10) for processing a coated substrate (2), which comprises:
- a process box (1) according to one of claims 1 through 7,
- one or a plurality of radiant heaters (12) for generating electromagnetic thermal radiation, which are arranged adjacent the at least one second housing section (5, 6; 27, 29) of the process box (1) serving for the heat treatment,
- a cooling device (14), which is coupled to the at least one first housing section (7, 9; 28) for its cooling.

9. Assembly (10) according to claim 8, wherein the radiant heaters (12) are arranged such that the intermediate space is situated at least partially, in particular completely, outside a common radiation field of the radiant heaters (12).

10. Assembly (10) according to claim 9, wherein the radiant heaters (12) are arranged exclusively above and/or below the process space (21).

11. Method for processing a coated substrate (2) in a transportable or stationary process box (1) according to one of claims 1 through 7, which comprises the following steps:
- Introducing the coated substrate (2) into a hollow space (11) of the process box (1),
- Gas-tight sealing of the hollow space (11) of the process box (1),
- Heat treating the coated substrate (2) by electromagnetic thermal radiation, which is generated by radiant heaters (12) arranged outside the process box (1) and impinges on the at least one second housing section (5, 6; 27, 29) of the process box (1) serving for the heat treatment, wherein during the heat treatment at least one gaseous substance is generated by the coated substrate (2),
- Cooling of the at least one first housing section (7, 9; 28) of the process box (1) during and optionally after the heat treatment,
- Inhibiting the diffusion of the gaseous substance generated during the heat treatment to the cooled housing section (7, 9; 28) through a separating wall (20) provided with one or a plurality of openings (23, 24, 37), which is arranged between the coated substrate (2) and and the cooled housing section (7, 9; 28).

12. Method according to claim 11, wherein an intermediate space (22) situated between the separating wall (20) and the cooled housing section (7, 9; 28) is at least partially, in particular completely, not irradiated by the electromagnetic thermal radiation.

13. Method according to one of claims 11 or 12, wherein a total opening area (25) of the one or a plurality of openings (23, 24, 37) of the separating wall (20) is reduced during the heat treatment by heating the separating wall to the maximum of 50%, preferably a maximum of 30%, more preferably a maximum of 10%, of the starting value before the heat treatment.

14. Method according to one of claims 11 through 13, wherein the hollow space (11) of the process box (1) is evacuated before and/or after the heat treatment of the coated substrate (2) and/or filled with a process gas.

## Revendications

1. Boîte de traitement (1) pour le traitement d'un substrat revêtu (2), présentant les caractéristiques suivantes:
- un boîtier étanche aux gaz (3), qui renferme un espace creux (11),
- le boîtier (3) comporte au moins une première section de boîtier (7, 9; 28) pouvant être couplée à un dispositif de refroidissement (14) pour son refroidissement,
- le boîtier (3) comprend au moins une deuxième section de boîtier (5, 6; 27, 29), qui est réalisée de telle sorte que le substrat (2) peut être traité thermiquement par rayonnement thermique électromagnétique incident, la au moins une deuxième section de boîtier (5, 6; 27, 29) étant différente de la au moins une première section de boîtier (7, 9; 28),
- le boîtier (3) est pourvu d'au moins un passage de gaz (16) obturable, débouchant dans l'espace creux (11), pour l'évacuation et l'introduction de gaz de procédé dans l'espace creux (11),
- l'espace creux (11) est divisé par au moins une paroi de séparation (20) en un espace de processus (21) destiné à recevoir le substrat (2) et un espace intermédiaire (22), la paroi de séparation (20) présentant une ou plusieurs ouvertures (23, 24, 37), **caractérisé en ce que** la paroi de séparation est disposée entre le substrat (2) et la première section de boîtier (7, 9; 28) pouvant être couplée au dispositif de refroidissement (14), la paroi de séparation (20) étant réalisée de telle sorte que, pendant le traitement thermique, une perte de masse d'une substance gazeuse produite par le traitement thermique du substrat revêtu (2) hors de l'espace de processus (21) est inférieure à 50 %, de préférence inférieure à 20 %, de préférence inférieure à 10 %, la paroi de séparation (20) étant réalisée de telle sorte qu'un rapport de surface, formé à partir d'une surface d'ouverture totale (25) de l'une ou de plusieurs ouvertures (23, 24, 37) divisée par une surface intérieure (26) de l'espace de processus (21), est compris entre 5 x 10⁻⁵ et 5 x 10⁻⁴.

2. Boîte de traitement (1) selon la revendication 1, dans laquelle la paroi de séparation (20) contient un matériau qui présente un coefficient de dilatation thermique tel qu'une surface d'ouverture totale (25) de l'une ou de plusieurs ouvertures (23, 24, 37) est réduite par chauffage de la paroi de séparation (20) pendant le traitement thermique à un maximum de 50 %, de préférence à un maximum de 30 %, plus préférablement à un maximum de 10 %, d'une surface d'ouverture totale (25) avant le traitement thermique.

3. Boîte de traitement (1) selon l'une des revendications 1 à 2, dans laquelle la paroi de séparation (20) contient un matériau ayant un coefficient de dilatation thermique supérieur à 5 x 10⁻⁶ K⁻¹.

4. Boîte de traitement (1) selon l'une des revendications 1 à 3, dans laquelle le boîtier (3) comprend un fond (27), un couvercle (29), ainsi qu'un cadre (28) reliant le fond (27) et le couvercle (29) entre eux, dans laquelle la section du boîtier pouvant être couplée à un dispositif de refroidissement (14) est formée par au moins une section de cadre (28).

5. Boîte de traitement (1) selon la revendication 4, dans laquelle le cadre (28) comprend une première section de cadre (30) reliée de manière fixe au fond (27) et une deuxième section de cadre (31) reliée de manière fixe au couvercle (29), dans laquelle les deux sections de cadre (30, 31) peuvent être reliées l'une à l'autre de manière étanche au gaz pour former l'espace creux (11).

6. Boîte de traitement (1) selon l'une des revendications 1 à 5, dans laquelle le boîtier (3) comprend:
- une section de boîtier d'une seule pièce (5-7), qui entoure l'espace creux (11), avec une ouverture de boîtier (6),
- un joint (9) pour la fermeture étanche au gaz de l'ouverture du boîtier (6).

7. Boîte de traitement (1) selon la revendication 6, dans laquelle la section du boîtier pouvant être couplée à un dispositif de refroidissement (14) comprend le joint (9).

8. Ensemble (10) pour le traitement d'un substrat revêtu (2), qui comprend:
- une boîte de traitement (1) selon l'une des revendications 1 à 7,
- un ou plusieurs éléments de chauffage par rayonnement (12) pour la production de rayonnement thermique électromagnétique, qui sont disposés à côté d'au moins une deuxième section de boîtier (5, 6; 27, 29) de la boîte de traitement (1) servant au traitement thermique,
- un dispositif de refroidissement (14), qui est couplé à au moins une première section de boîtier (7, 9; 28) pour son refroidissement.

9. Ensemble (10) selon la revendication 8, dans lequel les radiateurs à rayonnement (12) sont disposés de telle sorte que l'espace intermédiaire se trouve au moins sectionellement, en particulier complètement, en dehors d'un champ de rayonnement commun des radiateurs à rayonnement (12).

10. Ensemble (10) selon la revendication 9, dans lequel les radiateurs (12) sont disposés exclusivement au-dessus et/ou au-dessous de l'espace de processus (21).

11. Procédé de traitement d'un substrat revêtu (2) dans une boîte de traitement (1) transportable ou stationnaire selon l'une des revendications 1 à 7, qui comprend les étapes suivantes:
- Introduction du substrat revêtu (2) dans un espace creux (11) de la boîte de traitement (1),
- Scellement étanche au gaz de l'espace creux (11) de la boîte de traitement (1),
- Traitement thermique du substrat revêtu (2) par rayonnement thermique électromagnétique, qui est généré par des radiateurs rayonnants (12) disposés à l'extérieur de la boîte de traitement (1) et qui frappe au moins une deuxième section de boîtier (5, 6; 27, 29) de la boîte de traitement (1) servant au traitement thermique, au moins une substance gazeuse étant générée par le substrat revêtu (2) pendant le traitement thermique,
- Refroidissement d'au moins une première section de boîtier (7, 9; 28) de la boîte de traitement (1) pendant et éventuellement après le traitement thermique,
- Inhibition de la diffusion de la substance gazeuse générée pendant le traitement thermique vers la section refroidie du boîtier (7, 9; 28) à travers une paroi de séparation (20) munie d'une ou de plusieurs ouvertures (23, 24, 37), qui est disposée entre le substrat revêtu (2) et la section refroidie du boîtier (7, 9; 28).

12. Procédé selon la revendication 11, dans lequel un espace intermédiaire (22) situé entre la paroi de séparation (20) et la section de boîtier refroidie (7, 9; 28) n'est pas irradié au moins sectionellement, en particulier complètement, par le rayonnement thermique électromagnétique.

13. Procédé selon l'une des revendications 11 ou 12, dans lequel une surface totale d'ouverture (25) de l'une ou de plusieurs ouvertures (23, 24, 37) de la paroi de séparation (20) est réduite pendant le traitement thermique en chauffant la paroi de séparation au maximum à 50 %, de préférence au maximum à 30 %, de préférence au maximum à 10 % de la valeur de départ avant le traitement thermique.

14. Procédé selon l'une des revendications 11 à 13, dans lequel l'espace creux (11) de la boîte de traitement (1) est évacué avant et/ou après le traitement thermique du substrat revêtu (2) et/ou rempli d'un gaz de traitement.
